# FASCICULE DE BREVET EUROPEEN

(11) **EP 1 444 541 B1**
(45) Date de publication et mention de la délivrance du brevet: **25.04.2007**
(21) Numéro de dépôt: 02791901.8
(22) Date de dépôt: 13.11.2002
(51) Int. Cl.: G02B 6/42, G02B 6/43

(54) **DISPOSITIF ELECTRONIQUE MONOLITHIQUE MULTICOUCHES ET PROCEDE DE REALISATION D'UN TEL DISPOSITIF**
MONOLITISCHE ELEKTRONISCHE MEHRLAGENANORDNUNG UND DEREN HERSTELLUNGSVERFAHREN
MULTILAYER MONOLITHIC ELECTRONIC DEVICE AND METHOD FOR MAKING SAME

(30) Priorité: 15.11.2001 FR 0114784
(43) Date de publication de la demande: 11.08.2004
(73) Titulaire: COMMISSARIAT A L'ENERGIE ATOMIQUE, 75015 Paris (FR)
(72) Inventeur: BELLEVILLE, Marc, F-38120 Saint-Egrève (FR); HADJI, Emmanuel, F-38600 Fontaine (FR); ASPAR, Bernard, F-38140 Rives (FR)
(74) Mandataire: Poulin, Gérard
(86) Numéro de dépôt international: PCT/FR2002/003880
(87) Numéro de publication internationale: WO 2003/042741

(56) Documents cités:
- WO-A-99/45416
- US-A- 5 898 803
- US-B1- 6 285 808
- US-B1- 6 310 991
- BAZYLENKO M V ET AL: "FABRICATION OF LIGHT-TURNING MIRRORS IN BURIED-CHANNEL SILICA WAVEGUIDES FOR MONOLITHIC AND HYBRID INTEGRATION" JOURNAL OF LIGHTWAVE TECHNOLOGY, IEEE. NEW YORK, US, vol. 15, no. 1, 1997, pages 148-153, XP000642287 ISSN: 0733-8724
- JALALI B ET AL: "Advances in silicon-on-insulator optoelectronics" IEEE JOURNAL OF SELECTED TOPICS IN QUANTUM ELECTRONICS, NOV.-DEC. 1998, IEEE, USA, vol. 4, no. 6, pages 938-947, XP002204552 ISSN: 1077-260X
- FULLIN E ET AL: "CMOS-based technology for integrated optoelectronics: a modular approach" ELECTRON DEVICES MEETING, 1994. TECHNICAL DIGEST., INTERNATIONAL SAN FRANCISCO, CA, USA 11-14 DEC. 1994, NEW YORK, NY, USA,IEEE, 11 décembre 1994 (1994-12-11), pages 527-530, XP010131838 ISBN: 0-7803-2111-1
- KOH S ET AL: "OPTOELECTRONIC MULTICHIP MODULES FOR HIGH-SPEED COMPUTER SYSTEMS AND COMMUNICATION NETWORKS" OPTICAL ENGINEERING, SOC. OF PHOTO-OPTICAL INSTRUMENTATION ENGINEERS. BELLINGHAM, US, vol. 36, no. 5, 1 mai 1997 (1997-05-01), pages 1319-1325, XP000692361 ISSN: 0091-3286
- OROBTCHOUK R ET AL: "High-efficiency light coupling in a submicrometric silicon-on-insulator waveguide" APPLIED OPTICS, 1 NOV. 2000, OPT. SOC. AMERICA, USA, vol. 39, no. 31, pages 5773-5777, XP002204553 ISSN: 0003-6935

## Description

### DOMAINE TECHNIQUE

La présente invention concerne un dispositif électronique multicouche, et un procédé de réalisation d'un tel dispositif.

### ETAT DE LA TECHNIQUE ANTERIEURE

Dans les dispositifs électroniques monolithique multicouche, qui constituent aujourd'hui les circuits intégrés, les interconnexions sont un frein à l'augmentation des performances de ceux-ci.

Les évolutions technologiques en cours visent à diminuer le plus possible le retard des signaux véhiculés dans ces interconnexions et à minimiser la puissance dissipée dans celles-ci. Ainsi dans les interconnexions, le cuivre, dont la résistivité est plus faible que l'aluminium, est en train de remplacer celui-ci. De même des isolants à faible constante diélectrique sont introduits en remplacement des oxydes de silicium traditionnels. Mais le gain apporté par de telles évolutions reste limité.

Parallèlement à ces évolutions, les prévisions relatives aux fréquences de fonctionnement des futurs circuits intégrés ne cessent de croître : 10 GHz sont annoncés à court terme pour les horloges.

Pour réaliser des interconnexions rapides de relativement grande distance dans de tels futurs circuits intégrés, comme décrit dans le document référencé [1] en fin de description, on envisage d'utiliser des interconnexions optiques, par exemple dans des structures basées sur des substrats SOI ("Silicon-on-insulator"). Actuellement deux voies de recherche sont suivies : réaliser les interconnexions optiques en fin de fabrication de circuit, au-dessus de couches métalliques, ou bien réaliser les guides optiques dans le silicium, à côté des transistors. La première solution présente l'inconvénient d'encombrer les niveaux supérieurs d'interconnexion et donc de rendre plus difficile une amenée de puissance dans le circuit. La deuxième solution, dans le cas d'un nombre élevé d'interconnexions optiques, dégrade très fortement la densité d'intégration du circuit.

Un dispositif électronique avec connexion optoélectronique est connu de l'article de Seungug koh et al. intituté "optoelectronic multichip modules for high speed computer systems and communication networks", publié dans Opt. Eng. vol 36, No 5, pays 1319-1325, Mai 1997. Ce dispositif comprend une première couche de connection électrique et une seconde couche de guidage optique réalisées de part et d'autre d'un substrat.

L'invention a pour objet de pallier ces inconvénients des solutions de l'art connu.

### EXPOSÉ DE L'INVENTION

La présente invention concerne un dispositif électronique multicouche tel que défini dans la présente revendication 1.

La présente invention concerne également un procédé de réalisation d'un dispositif électronique multicouche, tel que defini en revendication indépendante 12.

### BRÈVE DESCRIPTION DES DESSINS

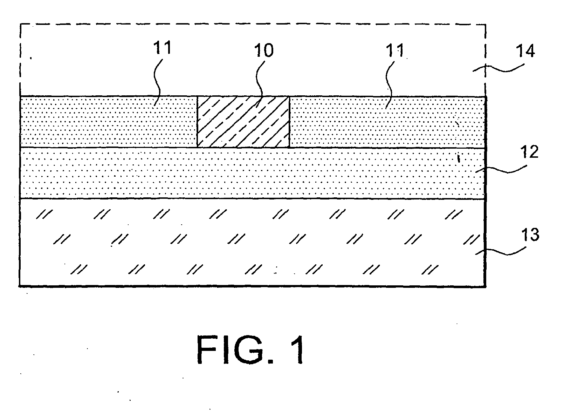

Les figures 1, 2 et 3 illustrent des guides optiques qui peuvent être utilisés dans le dispositif de l'invention après leur réalisation dans une première couche SOI et avant le report d'une seconde couche SOI supérieure, soit respectivement des guides en silicium monocristallin entourés d'un isolant SiO₂, des guides en silicium monocristallin gravés, et des guides en silicium monocristallin basés sur des structures à bande photonique interdite.

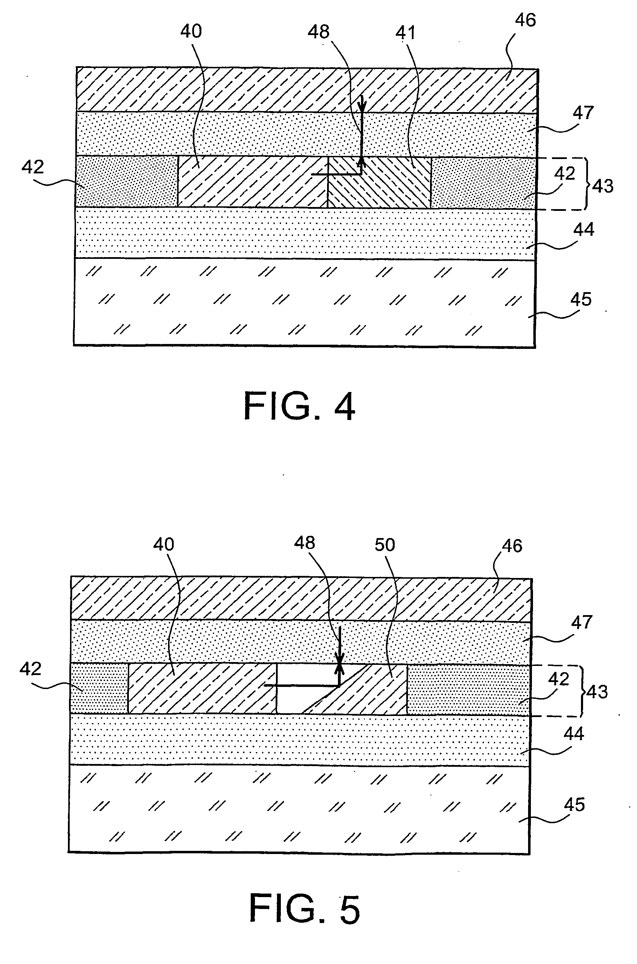

Les figures 4, 5 et 6 illustrent le dispositif de l'invention dans lequel des moyens de couplage optique sont réalisés dans la première couche SOI, respectivement à l'aide d'un coupleur quelconque, à l'aide d'un coupleur à réflexion, et à l'aide d'un coupleur à réseau de Bragg.

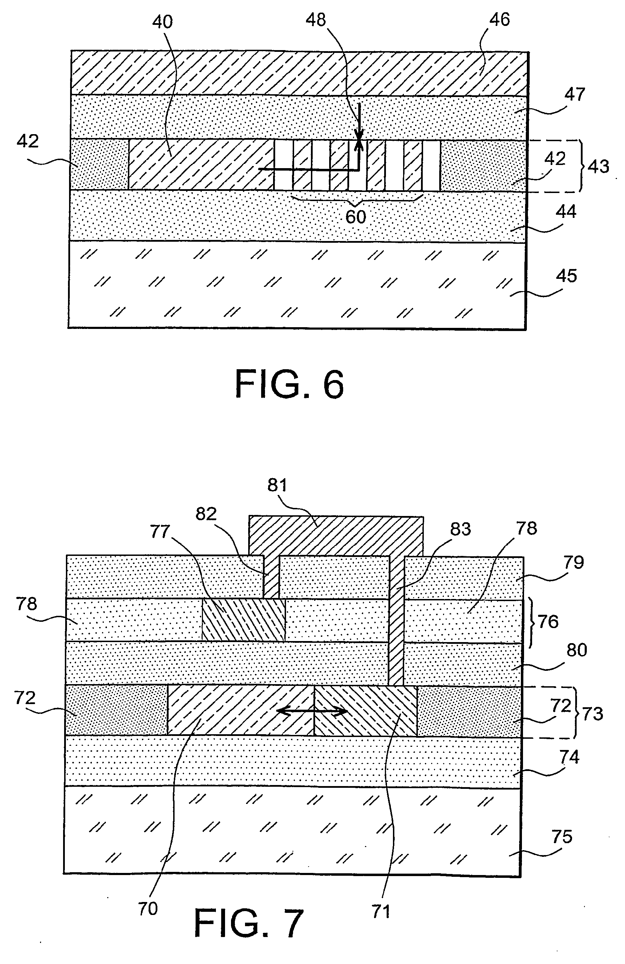

Les figures 7, 8, 9, 10 et 11 sont une présentation de différentes coupes technologiques du dispositif de l'invention, avec respectivement un élément optique actif réalisé dans la première couche SOI, un élément optique actif réalisé dans la seconde couche SOI à côté des dispositifs électroniques, un élément optique actif réalisé indépendamment puis reporté dans une cavité, un coupleur disposé dans la couche optique et un élément optique actif reporté dans une cavité réalisée à la fois dans la couche électrique et dans la couche inférieure, et un coupleur disposé dans la couche optique et un élément optique actif reporté dans une cavité réalisée dans la couche supérieure à la couche électrique.

### EXPOSÉ DÉTAILLÉ DE MODES DE RÉALISATION PARTICULIERS

L'invention concerne un dispositif électronique multicouche, qui comporte un circuit électronique formé d'au moins une couche apte à véhiculer une information sous forme électrique disposée au-dessus d'un circuit optique formé d'au moins une couche apte à véhiculer une information sous forme optique, et des moyens de connexions électriques et/ou optiques entre ces deux circuits.

Le circuit optique est situé en dessous du circuit électronique, car ce dernier se termine obligatoirement par une couche électrique permettant d'amener la puissance électrique.

Le procédé de réalisation d'un tel dispositif consiste à réaliser des guides optiques, qui peuvent être de tout type, dans une première couche. Cette couche peut également contenir des sources, des détecteurs, des amplificateurs, des modulateurs, des filtres, des aiguilleurs... dénommés dans la description "éléments optiques actifs", ou encore des moyens de couplage optiques.

Les sources de lumière sont par exemple des diodes électroluminescentes ou des lasers,... Les détecteurs peuvent être par exemple des photodiodes, des photoconducteurs, des phototransistors ... Ces éléments peuvent être de plus améliorés par des structures à bande photonique interdite. Par exemple, la présence de miroirs autour d'une photodiode renforce l'absorption de la lumière par un effet de résonance.

L'ensemble ainsi réalisé est ensuite assemblé, par adhésion moléculaire, avec un deuxième couche. Cette étape d'adhésion moléculaire peut éventuellement être précédée d'une étape de préparation des surfaces.

On obtient alors un ensemble de type "multicouche", dans lequel les guides optiques sont inclus dans la couche inférieure, et les composants électroniques traditionnels (MOS, bipolaires...) sont réalisés dans la couche supérieure.

Les éléments optiques actifs peuvent selon les cas être réalisés dans la couche supérieure, ou dans la couche inférieure en utilisant une technologie compatible avec la nature des couches utilisées. Par exemple dans le cas d'un substrat silicium, on utilise des couches SOI et les éléments optiques actifs sont en Si, SiGe, Si dopé erbium, ou encore des nanocristaux de silicium.

Dans le cas où les éléments optiques actifs ne sont pas réalisés dans la couche inférieure, et si la lumière a une direction différente de celle du plan des couches, on utilise des moyens de couplage réalisés dans la couche inférieure pour coupler la lumière entre les guides optiques et les éléments optiques actifs. On peut également, lorsque l'on ne sait pas intégrer les éléments optiques actifs dans les couches supérieures ou inférieures, réaliser dans les couches supérieures ou inférieures une cavité d'accueil dans laquelle un tel composant peut être reporté. Un tel report est également possible au-dessus de la couche supérieure.

De tels reports permettent d'associer des éléments optiques actifs réalisés dans une technologie différente de celle du substrat par exemple avec des composés III-V ou II-VI.

Différentes techniques de report sont possibles : par exemple par vignetage ou ajout d'une partie de couche, ou par adhésion moléculaire.

Le dispositif de l'invention comporte des entrées-sorties optiques pour l'ensemble ainsi réalisé. Ces entrées/sorties peuvent être de type latéral ou de type vertical, par exemple par couplage avec une fibre optique, ou par couplage via une micro-lentille. On peut également prévoir un auto-alignement des fibres en utilisant, par exemple, des rainures en forme de V ("V-groove").

D'autre part, les couches électrique et optique ne sont pas nécessairement en contact direct : des couches intermédiaires peuvent s'interposer entre les deux couches pour supporter des fonctions par exemple d'isolation optique et/ou électrique. Elles seront alors traversées par les moyens de connexion.

On va à présent considérer, à titre d'exemples, différents modes de réalisation permettant de mettre en évidence les caractéristiques du dispositif de l'invention.

### Guides optiques réalisés dans la couche SOI inférieure

Les figures 1, 2 et 3 présentent les guides optiques après leur réalisation et avant le report de la couche supérieure.

La figure 1 illustre un guide 10 en silicium monocristallin entouré de deux zones d'isolant 11 en SiO₂, disposés sur une couche 12 d'isolant en SiO₂ et un substrat 13 en silicium.

La lumière se propage dans le guide 10 perpendiculairement au plan de la coupe. Une préparation de la surface supérieure, avec éventuellement des étapes de dépôt et/ou de polissage peut être nécessaire pour permettre le report par adhésion moléculaire de la couche SOI supérieure 14. L'isolant SiO₂ peut être remplacé totalement, ou localement, par tout matériau d'indice optique différent de celui du silicium et compatible avec les procédés de fabrication utilisés.

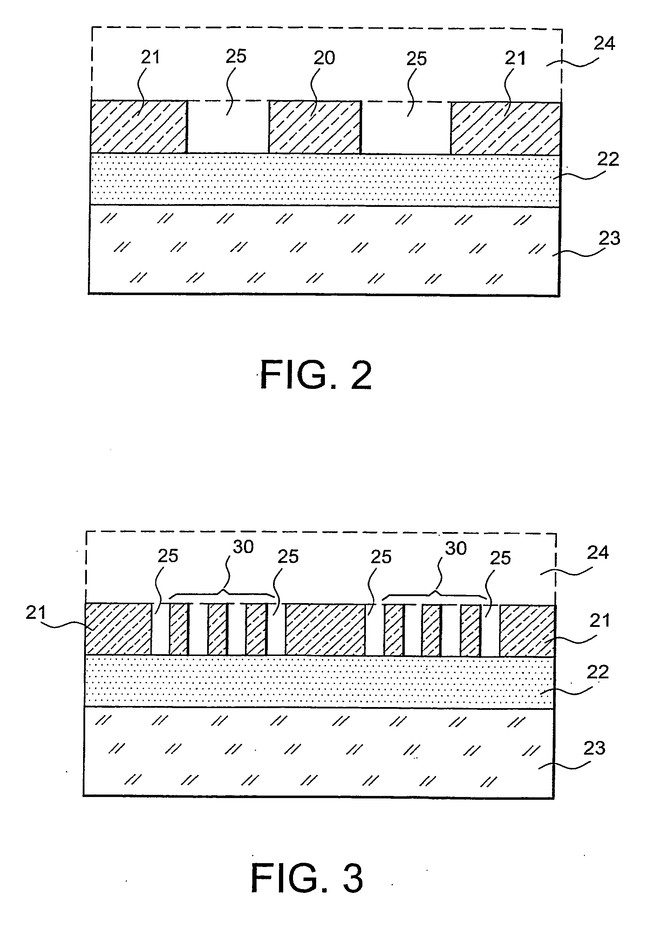

La figure 2 illustre un guide 20 et des motifs 21 en silicium monocristallin obtenus après gravure dans une couche de silicium monocristallin disposée sur une couche 22 de SiO₂ et un substrat 23 en silicium.

La lumière se propage dans le guide 20 perpendiculairement au plan de la coupe.

Les motifs 21 assurent des fonctions du type piliers mécaniques, ou scellement, et garantissent une surface apte à réaliser un report de la couche SOI supérieure 24. Cette couche 24 peut ainsi être reportée sur une couche dite "structurée". Les espaces 25 entre ces motifs 21 et le guide 20 sont remplis d'air, de vide, de gaz inerte ou de matériau de faible indice optique comme SiO₂ ou un polymère. Ces motifs 21 sont directement liés au procédé de report et ne sont pas toujours indispensables.

La figure 3 illustre un guide en silicium monocristallin 30 basé sur des structures à Bande Photonique Interdite (BIP).

Sur cette figure 3 on retrouve les éléments illustrés sur la figure 2, si ce n'est que le guide 20 a été défini par des structures BIP 30 remplies d'air, de vide, de gaz inerte ou de matériau de faible indice optique.

La couche SOI 24 peut là aussi être reportée sur une couche structurée.

### Moyens de couplage optique réalisés dans la couche SOI inférieure

La figure 4 illustre un guide en silicium monocristallin 40 associé à un coupleur 41, entourés de deux zones d'isolant SiO₂ 42 formant une couche optique 43 au-dessus d'une couche d'isolant 44 et d'un substrat en silicium 45. Une couche électrique 46 en silicium monocristallin est disposée au-dessus d'une couche 47 d'isolant SiO₂ et de la couche optique 43.

La lumière 48 se propage dans le guide optique 40 réalisé dans la couche optique 43, parallèlement au plan de la coupe. Cette lumière 48 est couplée entre le guide 40 et un élément source/détecteur, non représenté, situé dans la couche supérieure par un coupleur 41. Ce coupleur est de type horizontal/vertical. Tous les matériaux et interfaces rencontrés sur le chemin lumineux doivent garantir une bonne propagation de la lumière 48.

Le coupleur peut être de différents types : par exemple un coupleur par réflexion 50, comme illustré sur la figure 5. Ce coupleur 50 peut alors être réalisé en silicium, avec éventuellement un traitement de surface.

Le coupleur peut être un coupleur par réseau de Bragg 60, comme illustré sur la figure 6. Ce coupleur 60 est basé sur une structure périodique diffractante. L'usage d'un réseau comme décrit dans le document référencé [2], ou plus généralement d'une structure diffractante (par exemple un réseau de trous) permet alors de rediriger la lumière guidée dans le plan de la couche optique 43 vers la direction verticale (et inversement d'une direction hors du plan vers l'axe des guides).

Le document référencé [2] a, en effet, pour objet un couplage de lumière haute efficacité dans un guide SOI sous-micrométrique. Un couplage de lumière entre un guide d'onde d'épaisseur sous-micrométrique étant d'habitude réalisée en utilisant un coupleur à réseau, ce document envisage d'améliorer l'efficacité en disposant un miroir au-dessus du réseau.

### Présentation de différentes coupes technologiques possibles

La figure 7 illustre un mode de réalisation dans lequel le guide 70, les éléments optiques actifs 71 sont réalisés dans la couche optique 73.

Le guide 70 associé à un élément optique actif 71, situé entre deux zones d'isolant 72 de SiO₂, constituant ainsi la couche optique 73, sont disposés au-dessus d'une couche 74 d'isolant SiO₂ et d'un substrat 75 en silicium.

La couche électrique 76 constituée d'un élément MOS 77 entouré de deux zones 78 en isolant SiO₂ est disposée entre une couche supérieure 79 en isolant et une couche inférieure 80 en isolant, cette couche inférieure 80 étant disposée au-dessus de la couche optique 73. Un pavé métallique 81 disposé au-dessus de la couche supérieure en isolant 79 est relié par des connexions métalliques verticales 82 et 83 d'une part au composant MOS 77, et d'autre part à l'élément optique actif 71.

Toutes ces couches ont des épaisseurs comprises entre 0,1 et 1 µm.

Les guides 70, éléments optiques actifs 71 sont ainsi réalisés dans la première couche SOI. Les technologies utilisées sont compatibles avec la suite du procédé de l'invention : c'est-à-dire des étapes de report de la deuxième couche SOI, de fabrication des composants électroniques dans la couche SOI supérieure et des interconnexions.

Après préparation des surfaces (dépôt éventuel, polissage éventuel ...) de cette première couche SOI, la deuxième couche SOI est reportée sur celle-ci par adhésion moléculaire, par exemple en utilisant un procédé de type "Smart Cut". Suivant la nature des composants optiques utilisés, ce report peut être réalisé sur une première couche SOI structurée. Les dispositifs électroniques sont ensuite réalisés en utilisant les procédés technologiques classiques d'une technologie SOI : Cmos sur SOI par exemple.

Les composants électroniques ainsi que les éléments optiques actifs sont ensuite reliés aux niveaux d'interconnexion (premier métal, ou niveau d'interconnexions localisées). Selon la qualité des procédés de gravure utilisés, un niveau de lithographie supplémentaire peut être nécessaire pour réaliser les contacts vers les éléments optiques actifs, qui se trouvent en effet à une profondeur plus importante que les composants électroniques.

Les différents niveaux d'interconnexion sont ensuite réalisés avec des procédés microélectroniques standards bien connus de l'homme de métier, correspondant à la génération technologique utilisée.

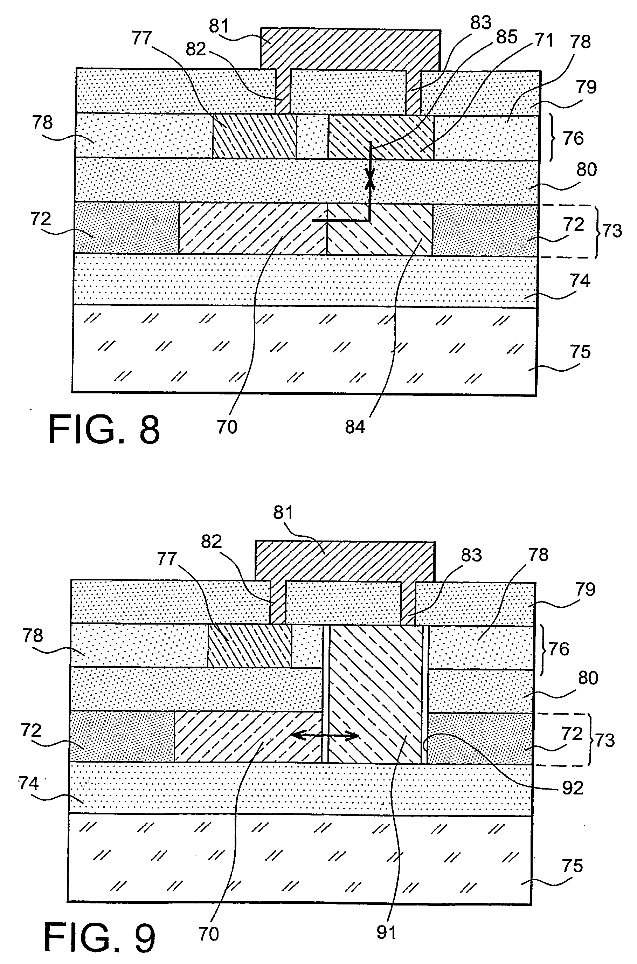

La figure 8 illustre un mode de réalisation dans lequel les éléments optiques actifs 71 sont réalisés dans la couche électrique supérieure 76 à côté des dispositifs électroniques.

Dans ce mode de réalisation on retrouve les mêmes éléments que sur la figure 7, si ce n'est que l'élément optique actif 71 est déplacé sur la couche électrique 76, et est remplacé sur la couche optique par un coupleur 84. Une liaison optique 85 permet de relier le guide 70 à l'élément optique actif 71 au travers du coupleur 84.

Les guides 70 et les coupleurs optiques 84 sont réalisés dans la première couche SOI. Les technologies utilisées sont, là aussi, compatibles avec la suite du procédé : report de la deuxième couche SOI, fabrication des composants électriques, des éléments optiques actifs dans la couche supérieure et des interconnexions.

Après préparation des surfaces, par dépôt éventuel, polissage éventuel... la deuxième couche SOI est reportée sur la première couche SOI par adhésion moléculaire, par exemple par un procédé de type "Smart Cut". Suivant la nature des composants optiques, ce report peut éventuellement être effectué sur une couche structurée.

Les composants électroniques 77 sont ensuite réalisés en utilisant les procédés technologiques classiques d'une technologie SOI (Cmos sur SOI par exemple). Les éléments optiques actifs 71 sont également réalisés dans cette couche SOI supérieure. L'ordre de réalisation des éléments optiques actifs 71 et des composants électroniques 77 dépend de l'optimisation des procédés technologiques utilisés.

Les interfaces entre les différentes couches sont optimisés pour que le transfert optique entre coupleur 84 et élément optique actif 71 soit de bonne qualité.

Les composants électroniques 77 ainsi que les éléments optiques actifs 71 sont ensuite reliés aux niveaux d'interconnexions (premier métal, ou niveau d'interconnexions localisées). Selon la qualité des procédés de gravure utilisés, un niveau de lithographie supplémentaire peut être nécessaire pour réaliser les contacts vers les éléments optiques actifs 71.

Tous les niveaux d'interconnexions sont ensuite réalisés avec les procédés micro-électroniques standards, correspondant à la génération technologique utilisée.

La figure 9 illustre un mode de réalisation dans lequel les éléments optiques actifs sont réalisés indépendamment puis reportés.

Les éléments illustrés sur cette figure 9 sont les mêmes que ceux illustrés sur la figure 8 si ce n'est l'élément optique actif 91 qui est reporté dans une cavité 92 qui s'étend entre la couche optique 73 et la couche électrique 76.

Le moment d'insertion de ces étapes de réalisation de la cavité 92 et du report de l'élément optique actif est optimisé en fonction de l'épaisseur des éléments optiques actifs à reporter : dans la première couche SOI pour des éléments très minces, ou au milieu des niveaux d'interconnexions pour des éléments plus épais, l'objectif étant de conserver un état technologique le plus planarisé possible après ces étapes. Toutes les variantes de profondeur de cavité sont possibles (de 0 à une cavité pénétrant dans le substrat inférieur).

Une fois les cavités 92 réalisées, on reporte dans celle-ci des éléments opto-électroniques 91 réalisés indépendamment et de nature éventuellement différente du silicium (Gaks InAs, InAsP, InGaAsP,... par exemple). Ce report peut être réalisé par des techniques de vignetage ou d'adhésion moléculaire.

Les composants électroniques 77 ainsi que les éléments optiques actifs 91 sont ensuite reliés aux niveaux d'interconnexions (premier métal, ou niveau d'interconnexions localisées). Selon la qualité des procédés de gravure utilisés, un niveau de lithographie supplémentaire peut être nécessaire pour réaliser les contacts vers les éléments optiques actifs 91. Par ailleurs, les contacts sur les éléments optiques ne sont pas nécessairement réalisés de la même manière que les contacts sur les éléments électriques.

Tous les niveaux d'interconnexions sont ensuite réalisés avec les procédés micro-éléctroniques standards, correspondant à la génération technologique utilisée.

Dans le cas illustré sur la figure 9, les éléments 91 rapportés émettent naturellement dans le plan des guides, et il suffit de les aligner correctement avec ceux-ci (cas des anneaux ou micro disques par exemple).

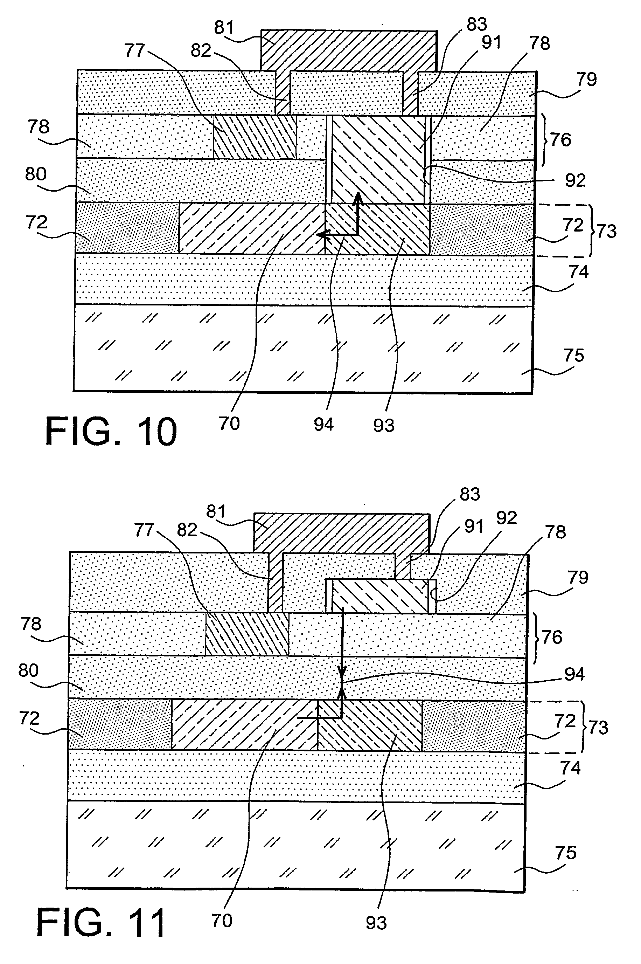

Si l'élément optique actif émet dans une direction différente, il convient d'utiliser des moyens de couplage de la lumière 93 tels que ceux définis précédemment. Ceux-ci sont alors intégrés dans la couche optique 73. L'élément optique actif 91 peut alors être disposé dans une cavité 92 formée à la fois dans la couche électrique 76 et dans la couche inférieure 80 à celle-ci comme illustré sur la figure 10, ou dans la couche supérieure 79 à la couche électrique 76 comme illustré sur la figure 11.

Toutes les combinaisons possibles entre les différents modes de réalisation décrits ci-dessus sont possibles, un élément source optique pouvant correspondre à un mode, un élément détecteur optique pouvant correspondre à un autre mode.

### REFERENCES

[1] "Optoelectronic interconnects for integrated circuits Achievements 1996-2000" de Henk Neefs. (Advanced research initiative in microelectronics, MEL-ARI OPTO, CEE, juin 2000, pages 2-8)
[2] "High-efficiency light coupling in a submicrometric silicon-on-insulator waveguide" de Régis Orobtchouk, Abdelhalim Layadi, Hamid Gualous, Daniel Pascal, Alain Koster et Suzanne Laval (Applied Optics, 1.11.2000, volume 39, N° 31, pages 5773-5777).

## Revendications

1. Dispositif électronique multicouche comprenant un substrat en silicium , comprenant :
- au moins une première couche (14) apte à véhiculer une information sous forme électrique ;
- au moins une seconde couche (10,11,12) apte à véhiculer une information sous forme optique ;
**caractérisé en ce que** ladite seconde couche est une couche silicium sur isolant, dite couche SOI, réalisée sur ledit substrat et ladite première couche est une couche SOI réalisée sur ladite seconde couche, et **en ce qu'**il comprend des moyens de connexion électriques et/ou optiques entre les première et seconde couches.

2. Dispositif selon la revendication 1, dans lequel la première couche (14) apte à véhiculer une information sous forme électrique comprend au moins un composant électronique, et la seconde couche (10,11,12) apte à véhiculer une information optique comprend au moins un guide optique (10,20,40).

3. Dispositif selon la revendication 2, dans lequel chaque guide optique (20) est une zone homogène de fort indice comprise entre des zones de plus faible indice.

4. Dispositif selon la revendication 1 comprenant des motifs (21) assurant des fonctions du type piliers mécaniques ou scellements, et garantissant une surface apte à réaliser le report des couches supérieures (24).

5. Dispositif selon la revendication 4, dans lequel les espaces entre les motifs (21) et/ou autour du guide optique (20) sont remplis d'air, de vide, de gaz inerte, ou de matériau de faible indice optique.

6. Dispositif selon la revendication 2, dans lequel chaque guide optique est un guide basé sur une structure à bande photonique interdite qui est remplie d'air, de vide, de gaz inerte, ou de matériau d'indice optique inférieur à celui du matériau guidant la lumière.

7. Dispositif selon la revendication 1, dans lequel la seconde couche apte à véhiculer une information optique comprend des moyens de couplage (41), et la première couche (46) apte à véhiculer une information électrique comprend au moins un élément optique actif, les moyens de couplage (41) permettant le couplage entre au moins un guide optique (40) et au moins un élément optique actif.

8. Dispositif selon la revendication 7, dans lequel les moyens de couplage (41) comprennent un coupleur par réflexion.

9. Dispositif selon la revendication 7, dans lequel les moyens de couplage (41) comprennent un coupleur par diffraction.

10. Dispositif selon la revendication 1 dans lequel la seconde couche comprend au moins un élément optique actif et les moyens de connexion sont des moyens électriques entre cet élément et la première couche.

11. Dispositif selon la revendication 1 comportant des entrées/sorties optiques.

12. Procédé de réalisation d'un dispositif électronique multicouche, **caractérisé en ce qu'**il comporte les étapes suivantes :
- réalisation d'au moins un guide optique dans une couche (10, 11, 12) SOI, dite seconde couche SOI, recouvrant un substrat de silicium ;
- assemblage du substrat en silicium ainsi recouvert avec une couche (14) SOI, dite première couche SOI, la première couche étant rendue solidaire de la seconde couche par adhésion moléculaire ;
- réalisation des composants électroniques dans la première couche.

13. Procédé selon la revendication 12, qui comporte en outre une étape de fabrication d'au moins un élément optique actif et/ou des moyens de couplage optique dans la seconde couche.

14. Procédé selon la revendication 12, qui comporte en outre une étape de fabrication d'au moins un élément optique actif dans la première couche (14).

15. Procédé selon la revendication 12, dans lequel la zone à fort indice du guide optique est obtenue par gravure.

16. Procédé selon la revendication 12, dans lequel la zone à faible indice du guide optique est obtenue par oxydation ou par nitruration.

17. Procédé selon la revendication 12, dans lequel l'écart des indices optiques du guide optique est obtenu par dopage.

18. Procédé selon la revendication 12, dans lequel on reporte au moins un élément optique actif (91) dans une cavité d'accueil (92).

## Claims

1. Multilayer electronic device comprising a silicon substrate, further comprising:
at least one first layer (14) capable of conveying information in an electrical form,
at least a second layer (10, 11, 12) capable of conveying information in an optical form,
**characterised in that** said second layer is a layer of silicon on oxide, named SOI layer, realized on said substrate, and said first layer is a SOI layer, realized on said second layer, and **in that** it comprises electrical and/or optical connection means between said first and second layers.

2. Device according to claim 1, in which the first layer (14) capable of conveying information in an electrical form comprises at least one electronic component, and the second layer (10, 11, 12) capable of conveying information in an optical form comprises at least one optical guide (10, 20, 40).

3. Device according to claim 2, in which each optical guide (20) is a high-index homogeneous region contained between lower-index regions.

4. Device according to claim 1, comprising patterns (21) fulfilling functions of the mechanical pillar or sealing type and providing a surface capable of accommodating the upper layers (24).

5. Device according to claim 4, in which the spaces between the patterns (21) and/or around the optical guide (20) are filled with air, vacuum, inert gas or material with a low refractive index.

6. Device according to claim 2, in which each optical guide is a guide based on a photonic band gap structure which is filled with air, vacuum, inert gas or a material with a refractive index lower than that of the material guiding the light.

7. Device according to claim 1, in which the second layer capable of conveying information in an optical form comprises coupling means (41), and the first layer (46) capable of conveying information in an electrical form comprises at least one active optical element, the coupling means (41) making it possible to obtain coupling between at least one optical guide (40) and at least one active optical element.

8. Device according to claim 7, in which the coupling means (41) comprise a reflection coupler.

9. Device according to claim 7, in which the coupling means (41) comprise a diffraction coupler.

10. Device according to claim 1, in which the second layer comprises at least one active optical element and the connection means are electrical means between this element and the first layer.

11. Device according to claim 1, having optical inputs/outputs.

12. Method for producing a multilayer monolithic electronic device, **characterized in that** it includes the following steps:
- producing at least one optical guide in a SOI layer (10, 11, 12) named second SOI layer, covering the silicon substrate,
- assembling the silicon substrate thus covered with a SOI layer (14) named first SOI layer, said first layer being bound to said second layer by molecular adhesion,
- producing electronic components in the first layer.

13. Method according to claim 12, which furthermore includes a step of fabricating at least one active optical element and/or optical coupling means in the second layer.

14. Method according to claim 12, which furthermore includes a step of fabricating at least one active optical element in the first layer (14).

15. Method according to claim 12, in which the high-index region of the optical guide is obtained by etching.

16. Method according to claim 12, in which the low-index region of the optical guide is obtained by oxidation or nitriding.

17. Method according to claim 12, in which the difference between the optical indices of the optical guide is obtained by doping.

18. Method according to claim 12, in which at least one active optical element (91) is put into a holding cavity (92).

## Patentansprüche

1. Elektronische Mehrlagenanordnung mit einem Siliciumsubstrat, umfassend:
- mindestens eine erste Schicht (14), fähig eine Information in elektrischer Form zu transportieren;
- mindestens eine zweite Schicht (10, 11, 12), fähig eine Information in optischer Form zu transportieren;
**dadurch gekennzeichnet, dass** die genannte zweite Schicht eine Silicium-auf-Isolator-Schicht ist, SOI-Schicht genannt, realisiert auf dem genannten Substrat, und die genannte erste Schicht eine auf der genannten zweiten Schicht realisierte SOI-Schicht ist,
und **dadurch**, dass sie zwischen der ersten und der zweiten Schicht elektrische und/oder optische Verbindungseinrichtungen umfasst.

2. Anordnung nach Anspruch 1, bei der die erste Schicht (14), fähig eine Information in elektrischer Form zu transportieren, wenigstens ein elektronisches Bauelement umfasst, und die zweite Schicht (10, 11, 12), fähig eine Information in optischer Form zu transportieren, wenigstens einen optischen Leiter (10, 20, 40) umfasst.

3. Anordnung nach Anspruch 2, bei der jeder optische Leiter (20) eine homogene Zone mit einer hohen Brechzahl zwischen Zonen mit niedrigerer Brechzahl ist.

4. Anordnung nach Anspruch 1 mit Mustern (21), die Funktionen des Typs mechanischer Pfeiler oder Versiegelung erfüllen und eine zur Übertragung der oberen Schichten (24) fähige Oberfläche gewährleisten.

5. Anordnung nach Anspruch 4, bei der die Räume zwischen den Mustern (21) und/oder um den optischen Leiter (20) herum Luft, Inertgas, Vakuum oder Material mit niedriger Brechzahl enthalten.

6. Anordnung nach Anspruch 2, bei der der optische Leiter ein Leiter ist, der auf einer Struktur des Typs Verbotenes Photonenband basiert, gefüllt mit Luft, Inertgas, Vakuum oder Material mit einer niedrigeren Brechzahl als derjenigen des das Licht leitenden Materials.

7. Anordnung nach Anspruch 1, bei der die zweite Schicht, fähig eine optische Information zu transportieren, Kopplungseinrichtungen (41) umfasst, und die erste Schicht (46), fähig eine elektrische Information zu transportieren, wenigstens ein aktives optisches Element umfasst, wobei die Kopplungseinrichtungen (41) die Kopplung zwischen wenigstens einem optischen Leiter (40) und wenigstens einem aktiven optischen Element ermöglicht.

8. Anordnung nach Anspruch 7, bei der die Kopplungseinrichtungen (41) einen Reflexionskoppler umfassen.

9. Anordnung nach Anspruch 7, bei der die Kopplungseinrichtungen (41) einen Diffraktionskoppler umfassen.

10. Anordnung nach Anspruch 1, bei der die zweite Schicht wenigstens ein aktives Element umfasst und die Verbindungseinrichtungen elektrische Einrichtungen zwischen diesem Element und der ersten Schicht sind.

11. Anordnung nach Anspruch 1 mit optischen Eingängen/Ausgängen.

12. Verfahren zur Realisierung einer elektronischen Mehrlagenanordnung, **dadurch gekennzeichnet, dass** es die folgenden Schritte umfasst:
- Realisierung wenigstens eines optischen Leiters in einer SOI-Schicht (10, 11, 12), zweite SOI-Schicht genannt, ein Siliciumsubstrat bedeckend;
- Zusammenbau des so bedeckten Siliciumsubstrats mit einer SOI-Schicht (14), erste SOI-Schicht genannt, wobei die erste Schicht mit der zweiten Schicht durch Molekularklebung bzw. Molekularbindung vereinigt wird;
- Realisierung der elektronischen Bauelemente in der ersten Schicht.

13. Verfahren nach Anspruch 12 mit außerdem einem Schritt zur Herstellung von wenigstens einem aktiven optischen Element und/oder optischen Kopplungseinrichtungen in der zweiten Schicht.

14. Verfahren nach Anspruch 12, das außerdem einen Schritt zur Herstellung von wenigstens einem aktiven optischen Element in der ersten Schicht (14) umfasst.

15. Verfahren nach Anspruch 12, in dem die eine hohe Brechzahl aufweisende Zone des optischen Leiters durch Ätzen realisiert wird.

16. Verfahren nach Anspruch 12, in dem die eine niedrige Brechzahl aufweisende Zone des optischen Leiters durch Oxidieren oder Nitrieren erzeugt wird.

17. Verfahren nach Anspruch 12, in dem man den Unterschied der Brechzahlen des optischen Leiters durch Dotierung erhält.

18. Verfahren nach Anspruch 12, in dem man wenigstens ein optisches Element (91) in einen Aufnahmehohlraum (92) überträgt.
